# EUROPEAN PATENT APPLICATION

(11) **EP 3 316 314 A1**
(43) Date of publication of application: **02.05.2018**
(21) Application number: 16881085.1
(22) Date of filing: 23.12.2016
(51) Int. Cl.: H01L 29/778, H01L 29/06, H01L 29/08

(54) **ALUMINUM-GALLIUM-NITRIDE COMPOUND/GALLIUM-NITRIDE HIGH-ELECTRON-MOBILITY TRANSISTOR**

(30) Priority: 29.12.2015 CN 201511016882
(71) Applicant: China Electronics Technology Group Corporation No.55 Research Institute, Nanjing, Jiangsu 210016 (CN)
(72) Inventor: REN, Chunjiang, Nanjing Jiangsu 210016 (CN); CHEN, Tangsheng, Nanjing Jiangsu 210016 (CN)
(74) Representative: Engelhard, Markus
(86) International application number: PCT/CN2016/111609
(87) International publication number: WO 2017/114296

(57) **Abstract**

The present invention discloses a nitride high electron mobility transistor having a strain balance of an aluminum gallium nitride insertion layer. According to one embodiment of the present invention, the transistor sequentially comprises: a substrate and a GaN buffer layer located on the substrate; an Al_{y}Ga_{1-y}N insertion layer located on the GaN buffer layer; an AlₓGa₁₋ₓN barrier layer located on the Al_{y}Ga_{1-y}N insertion layer opposite to the GaN buffer layer; a GaN cap layer located on the AlₓGa₁₋ₓN barrier layer; a "Γ"-shaped source electrode and drain electrode provided in recesses formed by the removal of the GaN cap layer and some thickness of the AlₓGa₁₋ₓN barrier layer; and a gate electrode located between the source electrode and the drain electrode. According to another embodiment of the present invention, an Al_{z}Ga_{1-z}N insertion layer is further included between the AlₓGa₁₋ₓN barrier layer and the GaN cap layer. The advantages of the present invention are that the AlGaN insertion layer with a high Al content is used to achieve the function of the AlN insertion layer, leading to a stronger controllability of the process; and the incorporation of the "Γ"-shaped source electrode and drain electrode facilitates formation of an ohmic contact and the formation of an ohmic contact, combined with the GaN cap layer, enables better control for the overall stress on the epitaxial layer, thereby ensuring the reliability of the device and optimizing the performance of the device.

## Description

### BACKGROUND OF THE INVENTION

### Field of the Invention

The present invention relates to a nitride high electron mobility transistor having a strain balance of an aluminum gallium nitride insertion layer.

### Description of Related Art

As the third generation wide bandgap compound semiconductor device, an aluminum gallium nitride (AlGaN) / gallium nitride (GaN) high electron mobility transistor (HEMT) is characterized by its high output power, high operating frequency, and good temperature resistance, in particular by its combination of high frequency and high power that is unavailable for current Si- and GaAs-based semiconductor techniques. , which allows it to obtain an unique edge in microwave applications and thus become a focus of research on semiconductor microwave power devices. Researchers have achieved a great breakthrough in microwave performance of an AlGaN/GaN HEMT by incorporation of an AlN insertion layer (L. Shen et al., IEEE Electron Device Lett., vol. 22, pp. 457-459, Oct. 2001.) combined with improvement of the crystal quality of epitaxial materials, and incorporation of SiN surface passivation (B. M. Green, et al., IEEE Electron Device Lett., Vol. 21, no. 6, pp. 268-270, 2000.) combined with employment of field plate structures (Ando et al., IEEE Electron Device Lett., Vol.24, No.5, pp. 289-291, 2003.). Particularly in output power capability, currently disclosed small-sized AlGaN/GaN HEMTs has an output power density up to above 30 W/mm in X band (Wu et al., IEEE Electron Device Lett., Vol. 25, No. 3, pp. 117-119, 2004.) and above 10 W/mm even in Ka band (T. Palacios et al., IEEE ELECTRON DEVICE LETTERS, VOL. 26, NO. 11, pp. 781-783, 2005.).

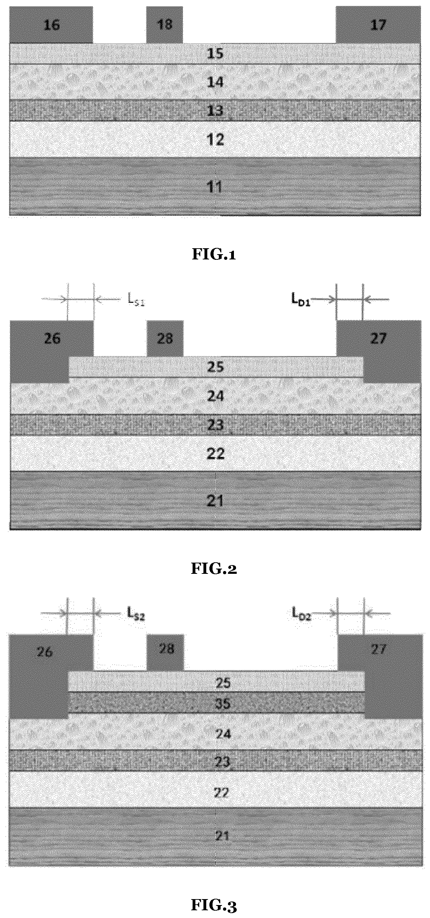

FIG. 1 is a schematic view of a conventional AlGaN/GaN HEMT device with an AlN insertion layer. The AlN insertion layer, on one hand, serves to decrease the effect of disordered scattering of AlGaN barrier layer alloys on electrons in a two-dimensional electron gas (2DEG) in a GaN channel layer, so as to increase mobility of the 2DEG. On the other hand, the AlN insertion layer has a wider bandgap and stronger piezoelectric and spontaneous polarization effects, and can effectively increase areal density of the 2DEG in the channel. In this way, the performance of the device is finally improved by the increase of mobility and areal density of the 2DEG in the GaN channel. Though the AlN insertion layer can improve device performance, it has a large lattice mismatch with the AlGaN barrier layer above and the GaN channel layer below, and accordingly, its thickness is required to be no more than 1 nm. If the AlN insertion layer has a thickness of more than 1 nm, the crystal quality thereof will substantially deteriorate and the defect density will increase significantly, which is unfavorable for improvement of device performance. As the epitaxial layer used in the existing AlGaN/GaN HEMT device is commonly obtained by organic chemical vapor deposition (MOCVD) and the control on the thickness of the epitaxial layer is much less precise than that of molecular beam epitaxy (MBE), it is thus very difficult to grow an AlN insertion layer with no more than 1 nm.

The GaN cap layer in the conventional AlGaN/GaN HEMT device shown in FIG. 1 serves to balance a strain force caused by the AlN insertion layer and the AlGaN barrier layer, with the thickness of the GaN cap layer generally between 1-5 nm. Another use of incorporation of the GaN cap layer is to suppress current collapse of an AlGaN/GaN HEMT (R. Coffie et al., IEEE Electron Device Lett., Vol. 23, No. 10, pp. 588-590, 2002.); however, disadvantageously, incorporation of the GaN cap layer will lead to decrease of the 2DEG concentration in the channel. Additionally, a source electrode and a drain electrode of the conventional AlGaN/GaN HEMT device are directly deposited on the GaN cap layer and require a high-temperature alloy process to form an ohmic contact with the epitaxial layer below them. During the high-temperature alloy process, the source electrode and drain electrode metals need to penetrate the GaN cap layer, AlGaN barrier layer and AlN insertion layer to form the ohmic contact with the 2DEG in the channel. Generally, with a GaN cap layer and an AlN insertion layer, a higher alloy temperature is required to obtain a better ohmic contact. This higher alloy temperature causes more serious thermal expansion and contraction of the source electrode and drain electrode metals during the alloy process, and even redistribution of the stress on the epitaxial layer, thereby adversely affecting consistency and reliability of the device performance.

### SUMMARY OF THE INVENTION

Object of the Invention: the object of the present invention is to provide a transistor with reliable performance and controllable growth.

Technical Solution: the present invention provides an aluminum gallium nitride/gallium nitride high electron mobility transistor, comprising: a substrate formed of silicon carbide, silicon or sapphire, wherein silicon carbide is most preferable for the substrate; a GaN buffer layer located on the substrate, wherein the thickness of the GaN buffer layer is preferably 1500-2000 nm; an Al_{y}Ga_{1-y}N insertion layer located on the GaN buffer layer, wherein 0.35 ≤ y ≤ 0.5 and the thickness of the Al_{y}Ga_{1-y}N insertion layer is most preferably 1-3 nm; an AlₓGa₁₋ₓN barrier layer located on the Al_{y}Ga_{1-y}N insertion layer opposite to the GaN buffer layer, wherein 0.2 ≤ x ≤ 0.25 and the thickness of the AlₓGa₁₋ₓN barrier layer is most preferably 10-20 nm; an Al_{z}Ga_{1-z}N insertion layer located on the AlₓGa₁₋ₓN barrier layer, wherein 0.30 ≤ z ≤ 0.4 and the thickness of the Al_{z}Ga_{1-z}N insertion layer is most preferably 1-3 nm; a GaN cap layer located on the Al_{z}Ga_{1-z}N insertion layer, wherein the thickness of the GaN cap layer is most preferably 1-3 nm; a source electrode and a drain electrode provided in recesses formed by removing the GaN cap layer, the Al_{z}Ga_{1-z}N insertion layer and some thickness of the AlₓGa₁₋ₓN barrier layer below the source electrode and the drain electrode, wherein the source electrode and the drain electrode are partially located on the GaN cap layer to form a "Γ"-shaped source electrode and drain electrode; and a gate electrode located between the source electrode and the drain electrode.

Advantageous Effect: the present invention utilizes an AlGaN insertion layer with a high content of Al instead of an AlN insertion layer. Compared to the AlN insertion layer, the AlGaN insertion layer has a smaller mismatch with the GaN channel layer and can grow thicker such that the growth process of the epitaxial material is more controllable, so as to facilitate improvement of consistency of the device; and also, 2DEG concentration and mobility can be increased by optimization of the Al content. In addition, the GaN cap layer and a part of the AlGaN barrier layer below the source electrode and the drain electrode of the AlGaN/GaN HEMT device are removed by etching, such that the source electrode and the drain electrode are closer to the 2DEG in the channel and can form an ohmic contact with the later at a lower alloy temperature, so as to avoid redistribution of the stress on the epitaxial layer caused by thermal expansion and contraction of the source electrode and drain electrode metals during a high-temperature process, thereby improving the consistency and reliability of device performance.

### BRIEF DESCRIPTION OF THE DRAWINGS

FIG. 1 is a schematic view of a general structure of an AlGaN/GaN HEMT.
FIG. 2 is a schematic view of the structure of an AlGaN/GaN HEMT according to one embodiment of the present invention.
FIG. 3 is a schematic view of the structure of an AlGaN/GaN HEMT according to another embodiment of the present invention.

### DETAILED DESCRIPTION OF THE INVENTION

The present invention is described below in further detail with reference to the accompanying drawings.

FIG. 2 shows one embodiment of an AlGaN/GaN HEMT according to the present invention. The AlGaN/GaN HEMT according to the present invention has a substrate 21. The substrate 21 is any one of sapphire, Si and SiC, and preferably, semi-insulating 4H-SiC and semi-insulating 6H-SiC are used as the substrate. Because of their properties such as high thermal conductivity and small lattice mismatch with GaN, the use semi-insulating 4H-SiC (0001) and semi-insulating 6H-SiC (0001) as the substrate is beneficial for growth of a high-quality GaN epitaxial material and also facilitates heat dissipation of the device. Currently, 4H-SiC and 6H-SiC substrates are commercially available from Cree and II-VI in USA.

A GaN buffer layer 22 is located on the substrate 21 and has a thickness of preferably 1500-2000 nm. The GaN buffer layer 22 generally has a high background carrier concentration that is unfavorable for improvement of the device breakdown. For this reason, Fe doping may be contemplated and in this respect, reference may be made to relevant literatures, but doping concentration and thickness of Fe doping must be controlled. The doping concentration is generally within 4 x 10¹⁸ cm⁻³ and the doping thickness is no more than 500-1000 nm upward from the substrate, that is, the thickness of about 1000 nm on the top of the GaN buffer layer remains undoped. In order to obtain a GaN buffer layer with good quality, a nucleation layer is generally located between the GaN buffer layer 22 and the substrate 21. The nucleation layer is mainly used as a transition so as to reduce the stress caused by the lattice mismatch between the GaN buffer layer 22 and the substrate 21. The selection of the nucleation layer is related to the substrate material, which is well known in the art and is not further described.

An Al_{y}Ga_{1-y}N insertion layer 23 is located on the GaN buffer layer, wherein 0.35 ≤ y ≤ 0.5 and the thickness of the Al_{y}Ga_{1-y}N insertion layer 23 is most preferably 1-3 nm. The band gap at the interface of the Al_{y}Ga_{1-y}N insertion layer 23 and the GaN buffer layer 22 is larger than that of the GaN buffer layer, such that a triangular potential well is formed at the interface of the GaN buffer layer 22 and the Al_{y}Ga_{1-y}N insertion layer 23 in close proximity to the GaN buffer layer. This triangular potential well, together with strong spontaneous and piezoelectric polarization effects of Group III nitrides themselves, leads to formation of a two-dimensional electron gas with a high areal density near the interface of the GaN buffer layer 22 and the Al_{y}Ga_{1-y}N insertion layer 23.

An AlₓGa₁₋ₓN barrier layer 24 is located on the Al_{y}Ga_{1-y}N insertion layer 23 opposite to the GaN buffer layer 22, wherein 0.2 ≤ x≤ 0.28 and the thickness of the AlₓGa₁₋ₓN barrier layer 24 is most preferably 10-20 nm. By use of spontaneous and piezoelectric polarization effects of the AlₓGa₁₋ₓN barrier layer 24, the triangle potential well formed at the interface of the GaN buffer layer 22 and the Al_{y}Ga_{1-y}N insertion layer 23 in close proximity to the GaN buffer layer may be deeper, thus obtaining a 2DEG with a higher areal density and facilitating the improvement of device performance.

A GaN cap layer 25 is located on the AlₓGa₁₋ₓN barrier layer 24, wherein the thickness of the GaN cap layer is most preferably 1-3 nm. The GaN cap layer 25 serves to balance the strain force caused by the Al_{y}Ga_{1-y}N insertion layer 23 and the AlₓGa₁₋ₓN barrier layer 24, and also enables inhibition of current collapse effect prevalent in the AlGaN/GaN HEMT, thus improving the microwave performance of the device.

The GaN buffer layer 22 (along with the nucleation layer between the GaN buffer layer 22 and the substrate 21), the Al_{y}Ga_{1-y}N insertion layer 23, the AlₓGa₁₋ₓN barrier layer 24, and the GaN cap layer 25 may be obtained by epitaxial growth sequentially on the substrate 21 using any suitable growing method such as MOCVD, RF-MBE, preferably MOCVD.

The GaN cap layer 25 and some thickness of the AlₓGa₁₋ₓN barrier layer 24 below a source electrode 26 and a drain electrode 27 are removed to form recesses. The recesses are formed by dry etching. The removal of both compounds GaN and AlGaN by dry etching is well known in the art and reference may be made to relevant literatures. The source electrode and the drain electrode are provided in the recesses and are partially located on the GaN cap layer to form a "Γ"-shaped source electrode and drain electrode. The source electrode 26 and the drain electrode 27 use the same metal layer, including, but not limited to, a multi-layer metal system such as Ti/Al/Ni/Au, Ti/Al/Mo/Au, and require a high-temperature alloy process to form an ohmic contact with the 2DEG, wherein the alloy temperature is preferably 680-780°C.

A gate electrode 28 is provided between the source electrode 26 and the drain electrode 27. The gate electrode 28, on one hand, serves to form a schottky contact with the GaN cap layer 25 such that changes in voltage on the gate electrode 28 can modulate the two-dimensional electron gas in the channel when the device is in operation; and on the other hand, serves to decrease the gate resistance of the device and improve the frequency characteristics of the device. The gate electrode 28 may use metals including, but not limited to, a multi-layer metal system such as Ni/Au/Tior Ni/Pt/Au/Pt/Ti or Ni/Pt/Au/Ni.

FIG. 3 shows another embodiment of the AlGaN/GaN HEMT according to the present invention, in which an Al_{z}Ga_{1-z}N insertion layer 35 is added on the basis of the first embodiment. The Al_{z}Ga_{1-z}N insertion layer 35 is located on the AlₓGa₁₋ₓN barrier layer 34, wherein 0.3 ≤ z ≤ 0.4 and the thickness of the Al_{z}Ga_{1-z}N insertion layer 35 is 1-3 nm. By use of spontaneous and piezoelectric polarization effects of the Al_{z}Ga_{1-z}N insertion layer 35, areal density of the 2DEG formed at the interface of the GaN buffer layer 32 and the Al_{y}Ga_{1-y}N insertion layer 33 in close proximity to the GaN buffer layer may be further increased and device performance is further improved.

It should be noted that the AlGaN insertion layer with a high Al content located on the GaN buffer layer in both embodiments of the present invention is aimed to increase the areal density and mobility of the 2DEG in the channel so as to achieve the effect of the AlN insertion layer shown in FIG. 1. Also, as compared to the AlN insertion layer, the AlGaN insertion layer with a high Al content has a smaller lattice mismatch with the GaN buffer layer, the AlGaN insertion layer may be designed to be thicker, facilitating more precise control in the process. In addition, the GaN cap layer mainly serves to balance the stress caused by the lattice mismatch between the AlGaN insertion layer and the AlGaN barrier layer below it and the GaN buffer layer. As incorporation of the GaN cap layer will lead to decrease of areal density of the 2DEG in the channel, the thickness of the GaN cap layer must not be too thick. The GaN cap layer has a large lattice mismatch with the AlGaN insertion layer and the AlGaN barrier layer and thus is subjected to a large compression stress, such that its effect of decreasing the 2DEG concentration in the channel is further enhanced. By incorporation of the "Γ"-shaped source electrode and drain electrode, some stress on the GaN cap layer may be released and the effect of decreasing the 2DEG concentration in the channel by incorporation of the GaN cap layer may be alleviated, thereby making a compromise between the performance and reliability of the device. The incorporation of the "Γ"-shaped source electrode and drain electrode is more favorable for electrons in the channel to enter the source electrode or drain electrode through the tunneling effect, and vice versa, so as to reduce the ohmic contact resistance of the device, thereby facilitating further improvement of device.

## Claims

1. An aluminum gallium nitride/gallium nitride high electron mobility transistor, comprising, sequentially from bottom to top, a substrate (21); a GaN buffer layer (22); an Al_{y}Ga_{1-y}N insertion layer (23), wherein 0.35 ≤ y ≤ 0.5; an AlₓGa₁₋ₓN barrier layer (24), wherein 0.2 ≤ x ≤ 0.28; a GaN cap layer (25); a source electrode (26) and a drain electrode (27) disposed at both ends of the GaN cap layer, wherein the GaN cap layer and some thickness of the AlₓGa₁₋ₓN barrier layer where the source electrode (26) and the drain electrode (27) are located are removed to form recesses, and the source electrode (26) and the drain electrode (27) are disposed in the recesses; and a gate electrode (28) located between the source electrode (26) and the drain electrode (27).

2. An aluminum gallium nitride/gallium nitride high electron mobility transistor according to claim 1, further comprising an Al_{z}Ga_{1-z}N insertion layer (35) located on the AlₓGa₁₋ₓN barrier layer (24), wherein 0.30 ≤ z ≤ 0.4, and the thickness of the Al_{z}Ga_{1-z}N insertion layer (35) is preferably 1-3 nm.

3. An aluminum gallium nitride/gallium nitride high electron mobility transistor according to claim 1, wherein the GaN buffer layer (22) is subjected to Fe doping, with the doping concentration being no more than 4 x 10¹⁸ cm⁻³ and the doping thickness being between 500-1000 nm upward from the substrate.

4. An aluminum gallium nitride/gallium nitride high electron mobility transistor according to claim 1, wherein the substrate (21) is one of silicon carbide, silicon or sapphire.

5. An aluminum gallium nitride/gallium nitride high electron mobility transistor according to claim 1, wherein the thickness of the GaN buffer layer (22) is 1500-2000 nm.

6. An aluminum gallium nitride/gallium nitride high electron mobility transistor according to claim 1, wherein the source electrode (26) and the drain electrode (27) are partially located on the GaN cap layer (25) to form a "Γ" shape.
